# EUROPÄISCHE PATENTSCHRIFT

(11) **EP 2 276 137 B1**
(45) Veröffentlichungstag und Bekanntmachung des Hinweises auf die Patenterteilung: **07.11.2018**
(21) Anmeldenummer: 10168764.8
(22) Anmeldetag: 07.07.2010
(51) Int. Cl.: H01L 31/02

(54) **Photovoltaikanlage**
Photovoltaic device
Installation photovoltaïque

(30) Priorität: 09.07.2009 DE 102009032288
(43) Veröffentlichungstag der Anmeldung: 19.01.2011
(73) Patentinhaber: Kostal Industrie Elektrik GmbH, 58513 Lüdenscheid (DE)
(72) Erfinder: Loh, Thomas, 58095, Hagen (DE); Landwehr, Frank, 44227, Dortmund (DE)
(74) Vertreter: Kerkmann, Detlef

(56) Entgegenhaltungen:
- EP-A1- 2 058 921
- EP-A1- 2 693 289
- DE-A1-102006 023 563
- DE-A1-102006 062 412
- JP-A- 2000 112 545

## Beschreibung

Die Erfindung betrifft eine Photovoltaikanlage mit Photovoltaikmodulen, die zu mehreren Modulsträngen verschaltet sind, wobei die Modulstränge mit jeweils einem zugeordneten Gleichspannungswandler verbunden sind, und die Ausgänge der Gleichspannungswandler am Eingang eines gemeinsamen Wechselrichters anliegen, der von den Gleichspannungswandlern räumlich getrennt angeordnet ist.

Photovoltaikanlagen mit Photovoltaikmodulen, die zu mehreren Modulsträngen verschaltet sind, wobei die Modulstränge mit jeweils einem zugeordneten Gleichspannungswandler verbunden sind, und bei denen die Ausgänge der Gleichspannungswandler am Eingang eines gemeinsamen Wechselrichters anliegen, sind beispielsweise aus der DE 199 19 766 A1 und der DE 101 36 147 B4 bekannt.

Die Figur 4 der japanischen Offenlegungsschrift JP 2000 112545 A zeigt eine gattungsgemäße Photovoltaikanlage, die mehrere Anordnungen aufweist, bei denen jeweils ein Modulstrang der Photovoltaikanlage mit einem Gleichspannungswandler elektrisch verbunden ist. Die Ausgänge aller Anordnungen sind an den Eingang eines räumlich getrennt angeordneten Wechselrichters angeschlossen.

Die deutsche Offenlegungsschrift DE 10 2006 062 412 A1 zeigt eine Photovoltaikanlage, die mehrere Modulstränge aufweist. Einem Modulstrang, der, etwa zur Anpassung an den für die Anlage zur Verfügung stehenden Bauraum eine zu den anderen Modulsträngen abweichende Anzahl von Photovoltaikmodulen aufweist, ist ein DC-Spannungsanpasser zugeordnet, der die Ausgangspannung dieses Modulstrangs an die Ausgangspannung der anderen Modulstränge anpasst. Die Photovoltaikanlage weist somit an nur einem ihrer Modulstränge einen DC-Spannungsanpasser auf.

Eine Photovoltaikanlage besteht üblicherweise aus mehreren Photovoltaikmodulen aus miteinander verbundenen Solarzellen, die miteinander in Reihe zu Modulsträngen, auch als Strings bezeichnet, verschaltet sind. Die Modulstränge liefern eine Gleichspannung, die zumeist nach einer Anpassung der Spannungshöhe durch einen Gleichspannungswandler, mittels eines Wechselrichters in eine Wechselspannung umgesetzt wird. Die vom Wechselrichter abgegebene Wechselspannung kann in das Netz eines lokalen Energieversorgers eingespeist werden.

Größere Photovoltaikanlagen weisen zumeist mindestens einen so genannten Generatoranschlusskasten auf. In diesem werden die einzelnen Modulstranganschlussleitungen zusammengeführt und mit einer Generatorhauptanschlussleitung verbunden, welche zum Eingangsanschluss eines Zentralwechselrichters führt. Bekannt ist es, im Generatoranschlusskasten neben den notwendigen Anschlussklemmen optional noch Strangsicherungen, Strangdioden, und/oder eine Strangstromüberwachung vorzusehen.

Die Gleichspannungswandler, die auch als DC/DC-Wandler oder DC/DC-Konverter bezeichnet werden, sind konstruktiv entweder den Modulsträngen zugeordnet, wie dies die DE 101 36 147 B4 zeigt, oder aber entsprechend der Darstellung der DE 199 19 766 A1 Bestandteile des Wechselrichters. Wie anhand der Zeichnung nachfolgend erläutert wird, weisen bekannte Anordnungen verschiedene Nachteile auf, welche durch die Erfindung soweit wie möglich vermieden werden sollen.

Es stellte sich die Aufgabe, eine Photovoltaikanlage zu schaffen, die sich neben einem einfachen und kostengünstigen Aufbau durch eine hohe elektrische Sicherheit und einen geringen Verkabelungsaufwand auszeichnet.

Diese Aufgabe wird erfindungsgemäß dadurch gelöst, dass die Gleichspannungswandler in einem einzigen Generatoranschlusskasten angeordnet sind, und dass innerhalb des Generatoranschlusskastens eine Steuervorrichtung angeordnet ist, welche eine Strangstromüberwachung durchführen kann und mit dem Zentralwechselrichter über eine Kommunikationsleitung in Verbindung steht. Die Anmeldung betrifft eine Photovoltaikanlage gemäß Anspruch 1. Im Folgenden sollen verschieden Ausführungen von Photovoltaikanlagen anhand der Zeichnung schematisch dargestellt und hinsichtlich ihrer vorteilhaften und nachteiligen Eigenschaften miteinander verglichen werden. Bei allen Ausführungen sind gleiche oder vergleichbar wirkende Merkmale mit jeweils den gleichen Bezugszeichen bezeichnet.

Es zeigen
- Figur 1: eine Photovoltaikanlage gemäß der Erfindung mit einem spannungsverstellenden Generatoranschlusskasten,
- Figur 2: eine konventionell aufgebaute Photovoltaikanlage mit einem Zentralwechselrichter,
- Figur 3: eine konventionell aufgebaute Photovoltaikanlage mit mehreren Modulstrangwechselrichtern.

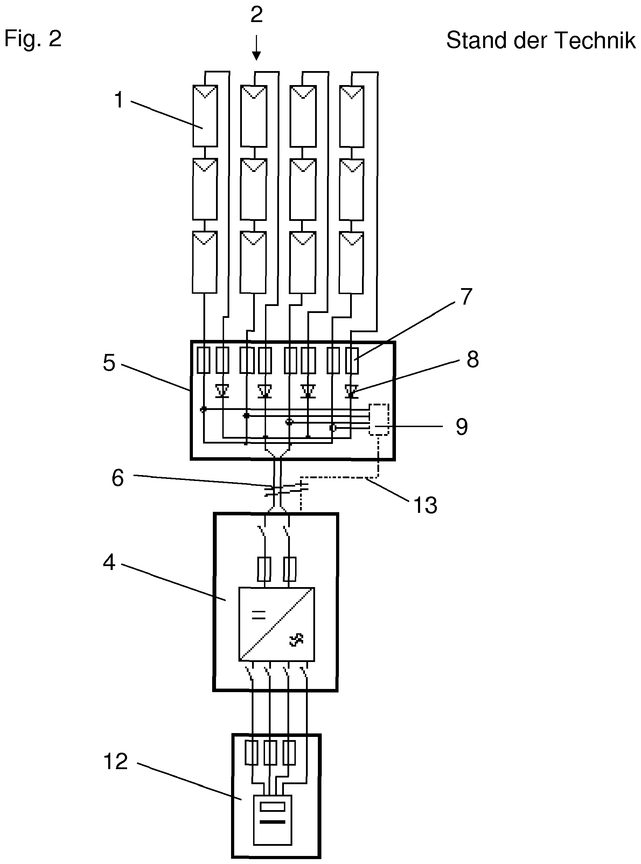

Figur 2 zeigt den grundsätzlichen Aufbau einer Photovoltaikanlage mit einem Zentralwechselrichter 4.

Bei dieser Photovoltaikanlage sind sämtliche Modulstränge 2 an einen Generatoranschlusskasten 5 angeschlossen, in welchem die Modulstränge 2 elektrisch zusammengeführt und mit einem querschnittstarken Sammelkabel, der Generatorhauptanschlussleitung 6, verbunden sind, welche wiederum die elektrische Verbindung zu dem Eingangsanschluss eines Zentralwechselrichters 4 herstellt. Durch diesen Aufbau kann der Verkabelungsaufwand und insbesondere die Gesamtlänge aller Modulstrangleitungen relativ gering gehalten werden.

Jedoch hat die Parallelschaltung vieler Modulstränge 2 auch Nachteile. Wenn mehr als zwei Modulstränge 2 parallel geschaltet sind, müssen Strangsicherungen 7 eingesetzt werden, um beispielsweise bei einem Fehler in einem Modulstrang 2 zu verhindern, dass in den fehlerhaften Modulstrang 2 ein Strom fließen kann, der groß genug ist, um Photovoltaikmodule 1 und Verkabelung zu beschädigen. Strangsicherungen 7 unterliegen besonderen Anforderungen, da sie einen Gleichstrom bei einem hohen Spannungswert unterbrechen müssen. Unter diesen Bedingungen bilden sich Lichtbögen aus, die von den Strangsicherungen 7 sicher gelöscht werden müssen, da sonst die Strangsicherungen 7 selbst ein erhebliches Brandrisiko darstellen würden. Aufgrund dieser Anforderungen sind Strangsicherungen 7 kostenintensiv.

Des weiteren werden die Strangsicherungen 7 in einem großen Temperaturbereich eingesetzt. Dadurch ist es schwierig, eine Auslösecharakteristik so sicherzustellen, dass eine Strangsicherung 7 einerseits unter hoher Umgebungstemperatur bei einem Nennstrom sicher nicht auslöst und andererseits unter niedriger Umgebungstemperatur bei weniger als dem doppelten Nennstrom der Photovoltaikmodule 1 sicher auslöst.

Durch hohe Temperaturschwankungen sind die Strangsicherungen 7 einer Alterung ausgesetzt, wodurch langfristig der Auslösestrom reduziert wird. Die Verfügbarkeit einer Photovoltaikanlage sinkt somit durch den Einsatz von Strangsicherungen 7. Sofern nicht eine Strangstromüberwachung 9 eingesetzt wird, muss im Fall eines Ertragsausfalles jede einzelne Strangsicherung 7 überprüft werden. Dies ist aufwändig und stellt auch eine Gefährdung des Wartungspersonals dar, da diese Arbeit in der Regel unter Spannung erfolgt.

Von einigen Modulherstellern wird bei einer Parallelschaltung von Modulsträngen 2 die Verwendung von Strangdioden 8 gefordert. Strangdioden 8 sollen einen Rückstrom verhindern, wenn ein Modulstrang 2 eine geringere Spannung als ein anderer aufweist. Auch Strangdioden 8 führen zu nachteiligen Eigenschaften. Durch ihre Flussspannung verursachen sie eine hohe Verlustleistung. Hierdurch wird der Ertrag der Photovoltaikanlage um ca. 0,2 % reduziert. Außerdem muss die Verlustleistung abgeführt werden. Speziell bei Hochleistungsmodulen werden Strangströme von mehr als 8 A erreicht, was zu einer Verlustleistung in der Größenordnung von 8 W je Strangdiode 8 führt. Die Strangdioden 8 müssen also über Kühlkörper gekühlt werden, was einen erheblichen Kostenaufwand verursacht.

Weiterhin sind die Strangdioden 8 bei nahen Blitzeinschlägen hohen Spannungsspitzen ausgesetzt, und somit ausfallanfällig. Es ist jedoch äußerst schwierig defekte Strangdioden 8 zu ermitteln, wodurch es möglich ist, dass eine Photovoltaikanlage lange Zeit in einem nicht optimalen Arbeitspunkt betrieben wird, und überdies bei einer Fehlersuche hohe Kosten verursacht.

Bei einer Parallelschaltung von vielen Modulsträngen 2 kann es vorkommen, dass der Defekt eines Modulstranges 2 für lange Zeit nicht über die Ertragsüberwachung erkannt wird, da der Ertrag aufgrund verschiedener Einflüsse im Bereich mehrerer Prozent schwanken kann. Dadurch kann die Photovoltaikanlage nicht ihren bestmöglichen Ertrag liefern. Aus diesem Grund werden im Generatoranschlusskasten 5 Stromsensoren 9 platziert, welche die einzelnen Strangströme messen und an eine, hier nicht dargestellte zentrale Leitstelle übermitteln. Hierdurch entsteht ein weiterer Systemaufwand durch eine zusätzliche Verkabelung von Kommunikationsleitungen 13 und daraus resultierend zusätzliche Kosten.

Da Generatoranschlusskästen 5 die Modulanschlussleitungen jeweils auf einer Sammelleitung zusammenführen, werden Generatoranschlusskästen 5 nur bei Photovoltaikanlagen eingesetzt, die einen Zentralwechselrichter 4 aufweisen. Da diese in der Regel einstufig aufgebaut sind und nur aus einer Wechselrichterbrücke bestehen, ist ihr Eingangsspannungsbereich stark eingeschränkt. Das führt dazu, dass es abhängig von den eingesetzten Photovoltaikmodulen 1 bei hohen Modultemperaturen dazu kommen kann, dass die MPP-Spannung (MPP = Maximum-Power-Point = optimaler Arbeitspunkt) des Photovoltaikgenerators unter den MPP-Bereich des Zentralwechselrichter 4 fällt. Dadurch wird nicht mehr der maximal mögliche Ertrag erbracht.

Durch eine teilweise Verschattung des Generatorfeldes, durch Mismatching oder durch Verschmutzung kann es vorkommen, dass einzelne Modulstränge 2 nicht in ihrem optimalen Arbeitspunkt betrieben werden. Der Zentralwechselrichter 4 hat aber nur einen MPP-Regler und kann daher nur die Spannung des gesamten Photovoltaikgenerators anpassen. Dadurch ergibt sich ein Minderertrag, der bei einer Parallelschaltung mehrerer Modulstränge 2 nicht vermeidbar ist.

Verschiedene Modultechnologien erfordern die Erdung eines Pols des Photovoltaikgenerators, was einen (nicht dargestellten) Transformator für den Zentralwechselrichter erforderlich macht. Ein Transformator in diesen Leistungsklassen stellt einen erheblichen Kostenfaktor dar und verursacht einen Ertragsverlust im Bereich von 1-2 %. Außerdem weist er ein relativ großes Gewicht und Volumen auf.

Bei der Parallelschaltung können nur Modulstränge 2 gleicher Länge (Anzahl der Photovoltaikmodule) parallelgeschaltet werden. Dies ist speziell bei Photovoltaikanlagen auf oder an Gebäuden ein Nachteil, da Restflächen nicht genutzt werden können oder die erforderliche Gleichspannungsverkabelung aufwändiger wird, um die entsprechende Länge der Modulstränge 2 wieder zu erreichen.

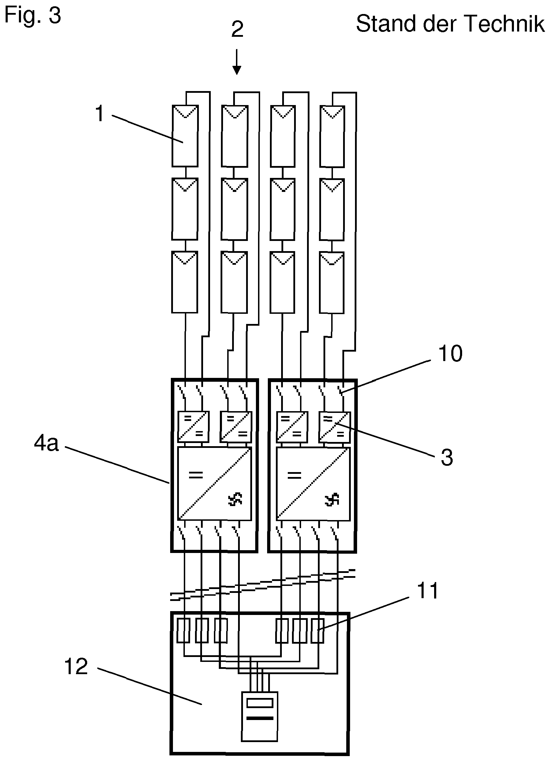

Insgesamt führt also die massive Parallelschaltung der Modulstränge 2 bei der Verwendung von Zentralwechselrichtern 4 zu Ertragseinbußen und zu wenig flexiblen Auslegungsmöglichkeiten. Einige dieser Nachteile lassen sich umgehen, wenn statt eines Zentralwechselrichters 4 mehrere Modulstrangwechselrichter 4a vorgesehen werden. Ein entsprechender Aufbau ist in der Figur 3 skizziert.

Bei Modulstrangwechselrichtern 4a wird für jeweils ein bis zwei Modulstränge 2 ein Gleichspannungswandler 3 eingesetzt, um eine Spannungsanpassung des/der Modulstränge 2 zur Zwischenkreisspannung des Wechselrichters 4a zu erreichen. Dadurch kann der Eingangsspannungsbereich erheblich erweitert werden, wodurch auch MPP-Punkte bei kleineren Spannungen erreicht werden können, wie sie bei einer Teilverschattung der Modulstränge 2 auftreten. Wenn nicht mehr als zwei Modulstränge 2 parallel geschaltet sind, können die Strangsicherungen entfallen und wenn nur ein Modulstrang 2 pro Gleichspannungswandler 3 angeschlossen ist, wie in der Figur 3 dargestellt, können auch die Strangdioden eingespart werden, da der Gleichspannungswandler 3 einen Rückstrom verhindert.

Da jeder Gleichspannungswandler 3 den MPP separat regelt, stehen von jedem Modulstrang 2 Informationen zu Strom und Spannung zur Verfügung. Damit werden weitere Strommessungen zur Detektion von Fehlern überflüssig.

Wenn Modultechnologien eingesetzt werden, die eine Erdung eines Photovoltaikgeneratorpols erfordern, werden häufig in den Wechselrichtern 4a Gleichspannungswandler 3 eingesetzt, die die Modulstränge galvanisch von den Modulstrangwechselrichter 4a trennen. Galvanisch trennende Gleichspannungswandler 3 haben gegenüber den alternativ einsetzbaren Niederfrequenztransformatoren Vorteile im Preis, Gewicht und Größe.

Modulstrangwechselrichter 4a weisen jedoch auch Nachteile auf. So besitzen sie zumeist eine relativ begrenzte Leistung, da ab einer bestimmten Leistung die Gleichspannungsverkabelung zu kostenaufwändig wird. Daher weisen sie in der Regel auch nicht mehr als drei Gleichspannungswandler 3 auf. Zur Ausbildung großer Photovoltaikgeneratoren werden folglich relativ viele Modulstrangwechselrichter 4a benötigt. Werden diese jeweils günstig zu den angeschlossenen Modulsträngen 2 angeordnet, ergibt sich zumeist ein hoher Verkabelungsaufwand auf der Wechselspannungsseite der Modulstrangwechselrichter 4a.

Bei Modulstrangwechselrichtern 4a muss jeder Modulstrang 2 durch einen Gleichspannungsfreischalter 10 abgeschaltet werden können, um im Falle eines Wechselrichterdefekts den Modulstrangwechselrichter 4a von den angeschalteten Modulsträngen 2 zu trennen. Diese Gleichspannungsfreischalter 10 stellen bei großen Photovoltaikanlagen einen erheblichen Kostenfaktor dar. Des weiteren müssen für alle Wechselrichter 4a Leitungsschutzsicherungen 11 in einem Wechselspannungsschaltschrank 12 platziert werden. Der Wechselspannungsschaltschrank 12 dient insbesondere als Einspeisepunkt der Photovoltaikleistung in ein Verteilungsnetz.

Die Kosten von mehreren Modulstrangwechselrichtern 4a in großen Photovoltaikanlagen sind höher als die Kosten von nur einfach benötigten Zentralwechselrichtern 4, da die Wechselrichterbrücke, das Gehäuse usw. hierbei mehrfach vorhanden sind.

Allgemein müssen bei großen Photovoltaikanlagen, die über einen Transformator ihre Ausgangsspannung in ein Mittelspannungsnetz einspeisen, die Wechselrichter (4, 4a) über ein Rundsteuersignal abregelbar sein. Das Signal wird durch einen (nicht dargestellten) Rundsteuerempfänger dekodiert und muss dann an alle Wechselrichter (4, 4a) weitergeleitet werden. Dies ist besonders bei Modulstrangwechselrichtern 4a aufwändig, da hier entweder mehrere Rundsteuerempfänger erforderlich sind oder ein signalverteilendes Leitungssystem zwischen den Modulstrangwechselrichtern 4a benötigt wird.

Ein weiteres (in den Figuren nicht dargestelltes) Konzept stellen so genannte modulintegrierte Konverter dar. Hierbei wird in jedes Photovoltaikmodul ein Gleichspannungswandler oder ein Wechselrichter integriert. Dieses Konzept hat sich im Markt jedoch bisher nicht durchsetzen können, da durch den Konverter in jedem Photovoltaikmodul die Module überproportional teuer werden und dennoch häufig der Wirkungsgrad eher gering ist. Dadurch können diese Systeme den Vorteil, dass jedes Photovoltaikmodul einzeln im MPP geregelt wird und eine Beschattung eines Moduls nicht die Leistung anderer Photovoltaikmodule verringert in der Regel nicht in einen höheren Gesamtertrag umsetzen.

Als weiterer Nachteil kommt hinzu, dass jedes Photovoltaikmodul mit einer Leitstelle kommunizieren können muss, da sonst ein defektes Photovoltaikmodul nicht auffindbar ist. Ebenfalls nachteilig ist, dass der Wechselrichter häufig nicht die selbe Lebensdauer aufweist, wie die Photovoltaikmodule. Ein Wechselrichterdefekt erfordert bei solchen Anlagen den Austausch des ganzen betroffenen Photovoltaikmoduls, wodurch die Austauschkosten erheblich sind.

Bei der Montage der Photovoltaikanlage entsteht ein zusätzlicher Aufwand dadurch, dass jedes Photovoltaikmodul mit der Seriennummer und Position im Feld erfasst werden muss und eine eindeutige Nummer für die Kommunikation vergeben werden muss, damit man defekte Photovoltaikmodule wiederfinden kann.

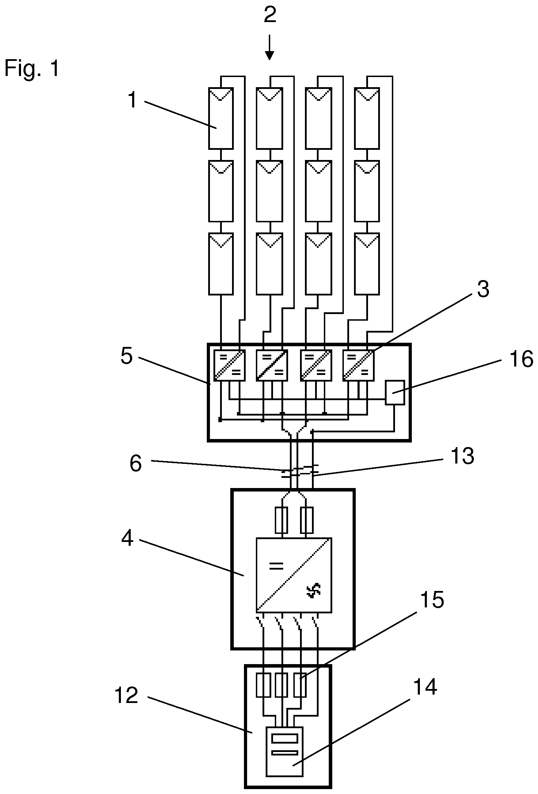

Ziel der Erfindung war es, soweit wie möglich die Vorteile der zuvor beschriebenen etablierten Konzepte zusammenzuführen, und die Nachteile zu reduzieren. Das erfindungsgemäße Aufbaukonzept ist in der Figur 1 skizziert.

Die Photovoltaikanlage besteht aus mehreren Modulsträngen 2, deren Anschlussleitungen zu einem Generatoranschlusskasten 5 geführt sind. Innerhalb des Generatoranschlusskastens 5 sind mehrere Gleichspannungswandler 3 angeordnet, wobei mit jedem Gleichspannungswandler 3 jeweils ein oder höchstens zwei Modulstränge 2 verbunden sind. Die Ausgangsspannungen aller Gleichspannungswandler 3 werden zusammengefasst und über eine Generatorhauptanschlussleitung 6 einem Zentralwechselrichter 4 zugeführt, welcher wiederum mit einem Wechselspannungsschaltschrank 12 verbunden ist, der insbesondere zur Einspeisung der vom Photovoltaikgenerator gelieferten elektrischen Energie in ein Verteilungsnetz vorgesehen ist. Bestandteil des Wechselspannungsschaltschranks 12 ist daher zumindest ein hier symbolisch dargestellter Einspeisezähler 14.

Der Zentralwechselrichter 4 und der Wechselspannungsschaltschrank 12 können auch eine Baueinheit miteinander bilden. In wenigstens eine dieser Komponenten ist eine, hier nicht als Einzelteil dargestellte, elektronische Steuerungseinheit für die Photovoltaikanlage integriert, die vorzugsweise unter Verwendung eines Mikroprozessors arbeitet.

Der Generatoranschlusskasten 5 ist vom Zentralwechselrichter 4 räumlich getrennt angeordnet und vorzugsweise in einer möglichst günstigen räumlichen Lage zur Gesamtheit der Modulstränge 2 platziert. Der Verkabelungsaufwand kann so insgesamt optimiert werden, da einerseits die Gesamtlänge der Anschlussleitungen der Modulstränge 2 möglichst klein gehalten werden kann und andererseits die Verkabelung zwischen dem Generatoranschlusskasten 5 und dem Zentralwechselrichter 4 auf die Generatorhauptanschlussleitung 6 und auf eine Kommunikationsleitung 13 beschränkt sein kann, wobei die Kommunikationsleitung 13 mit einer Steuervorrichtung 16 innerhalb des Generatoranschlusskastens 5 in Verbindung steht.

Da am Generatoranschlusskasten 5 nur maximal zwei Modulstränge 2 pro Gleichspannungswandler 3 angeschlossen sind, werden keine Strangsicherungen benötigt. Hierdurch werden erhebliche Kosten eingespart und zudem das Gefährdungspotential durch weniger erforderlich werdende Wartungsarbeiten reduziert. Ein weiterer Punkt ist, dass die Verfügbarkeit der Photovoltaikanlage steigt, da keine Schmelzsicherungen mehr auslösen können und dann erst wieder ersetzt werden müssen.

Ist, wie in der Figur 1 dargestellt, jeweils nur ein Modulstrang 2 an jeden Gleichspannungswandler 3 angeschlossen, so können zudem die Strangdioden entfallen, wodurch ein verbesserter Wirkungsgrad erzielt wird. Die in der Figur 1 skizzierte Photovoltaikanlage weist nur einen einzigen Generatoranschlusskasten 5 auf.

Der MPP wird durch die Gleichspannungswandler 3 individuell für jeden Modulstrang 2 geregelt. Dadurch erzielt die Photovoltaikanlage bei Teilverschattung oder Parameterstreuung einen besonders hohen Ertrag. Der MPP-Bereich kann zudem so weit vergrößert werden, dass auch bei einer Teilverschattung der richtige MPP angefahren werden kann. Die Photovoltaikgeneratorkonfiguration wird dadurch wesentlich flexibler. Außerdem müssen nicht alle Modulstränge die gleiche Länge und Technologie aufweisen.

Die Messung der Strangströme durch eine von der Steuervorrichtung 16 durchführbaren Strangstromüberwachung kann zur MPP-Regelung verwendet werden. Dadurch wird eine doppelte Strommessung vermieden, was hilft die Kosten zu reduzieren. Die Messung der Strangströme kann noch vorteilhaft durch eine Überwachung der Strangspannungen ergänzt werden. Damit ist eine wesentlich bessere Diagnose der Modulstränge 2 möglich, wodurch der Ertrag gesichert werden kann.

Besonders vorteilhaft ist, dass durch die in den Generatoranschlusskasten 5 integrierten Gleichspannungswandler 3 die Spannung in der Generatorhauptanschlussleitung 6 erhöht werden kann, wodurch der Strom entsprechend sinkt. Dies bedeutet entweder weniger Verluste oder es kann ein geringerer Kabelquerschnitt gewählt werden. Da die Spannung hier immer über der Netzspannung liegt, ist der notwendige Kabelquerschnitt auf jeden Fall kleiner als bei der Wechselspannungskopplung bei einem Modulstrangwechselrichterkonzept.

Durch die gleichmäßigere Eingangsspannung für den Zentralwechselrichter 4 können die Bauteile des Zentralwechselrichters 4 hinsichtlich der erwarteten Verlustleistung optimiert werden, wodurch die Kosten sinken und der Wirkungsgrad gesteigert werden kann.

Auf der Wechselspannungsseite des Zentralwechselrichter 4 ist die Verkabelung einfacher als bei einem Modulstrang- oder Multimodulstrangwechselrichter 4a, wie aus einem Vergleich mit der Figur 3 leicht ersichtlich ist. Es wird auch nur ein Sicherungssatz 15 benötigt.

Besonders vorteilhaft ist es, wenn die Gleichspannungswandler 3 als galvanisch trennende Gleichspannungswandler ausgeführt sind. In diesem Fall können an den Generatoranschlusskasten 5 alle Modultechnologien angeschlossen werden und beliebig geerdet werden.

Bei Photovoltaikanlagen mit Strangmodulen, die eine Erdung eines Photovoltaikgeneratorpols erfordern, entfällt dadurch der Niederfrequenztransformator vor dem Zentralwechselrichter 4. Dies schafft eine erhebliche Kostenreduktion und beseitigt die elektrischen Verluste, welche durch den Transformator verursacht werden.

Bei galvanisch trennenden Gleichspannungswandlern 3 kann der Strom durch ein Signal vom Wechselrichter oder einer Leitstelle sicher unterbunden werden. Wenn die Gleichspannungswandler 3 nicht mehr angesteuert werden, wird die Generatorhauptanschlussleitung 6 nicht mehr mit Energie gespeist. Wenn nun auch der Zentralwechselrichter 4 vom Mittelspannungsnetz getrennt wird, ist der Zentralwechselrichter 4 und die Generatorhauptanschlussleitung 6 sicher von allen Spannungsquellen abgeschaltet. Eine zusätzliche Gleichspannungstrennstelle kann hierdurch entfallen. Hierbei wird entgegen der heutigen Praxis nicht nur der Zentralwechselrichter 4 freigeschaltet, sondern ebenfalls die Gleichspannung führende Generatorhauptanschlussleitung 6.

Bei einem galvanisch trennenden Gleichspannungswandler 3 im Generatoranschlusskasten 5 können zudem Modulstränge 2 stromlos geschaltet werden, ohne die gesamte Photovoltaikanlage abzuschalten. Dies reduziert den Ertragsausfall bei Wartungsarbeiten an einzelnen Modulsträngen 2.

Ebenfalls vorteilhaft ist, dass Teile der Photovoltaikanlage auch nacheinander in Betrieb genommen werden können. Dies ist beim Aufbau großen Anlagen von Vorteil, bei denen der Ausbau eines Photovoltaikfeldes eine gewisse Zeit in Anspruch nehmen kann.

### Bezugszeichen

- 1: Photovoltaikmodule
- 2: Modulstränge
- 3: Gleichspannungswandler
- 4, 4a: Wechselrichter
- 4: Zentralwechselrichter
- 4a: Modulstrangwechselrichter
- 5: Generatoranschlusskasten
- 6: Generatorhauptanschlussleitung
- 7: Strangsicherungen
- 8: Strangdioden
- 9: Strangstromüberwachung (Stromsensoren)
- 10: Gleichspannungsfreischalter
- 11: Leitungsschutzsicherungen
- 12: Wechselspannungsschaltschrank
- 13: Kommunikationsleitung(en)
- 14: Einspeisezähler
- 15: Sicherungssatz
- 16: Steuervorrichtung

## Patentansprüche

1. Photovoltaikanlage
mit Photovoltaikmodulen (1), die zu mehreren Modulsträngen (2) verschaltet sind,
wobei die Modulstränge (2) mit jeweils einem zugeordneten Gleichspannungswandler (3) verbunden sind,
und die Ausgänge der Gleichspannungswandler (3) am Eingang eines gemeinsamen Wechselrichters (4) anliegen,
der von den Gleichspannungswandlern (3) räumlich getrennt angeordnet ist,
**dadurch gekennzeichnet,**
**dass** die Gleichspannungswandler (3) in einem einzigen Generatoranschlusskasten (5) angeordnet sind, und dass innerhalb des Generatoranschlusskastens (5) eine Steuervorrichtung (16) angeordnet ist, welche eine Strangstromüberwachung durchführen kann und mit einem Zentralwechselrichter (4) über eine Kommunikationsleitung (13) in Verbindung steht.

2. Photovoltaikanlage nach Anspruch 1, **dadurch gekennzeichnet, dass** die Gleichspannungswandler (3) die angeschlossenen Modulstränge (2) galvanisch vom Wechselrichter (4) trennen.

## Claims

1. Photovoltaic system
having photovoltaic modules (1) which are interconnected to modular strings (2),
whereby each of the modular strings (2) is connected to a direct voltage converter (3) assigned to it,
and the outputs of the direct voltage converters (3) are applied to the input of a common power inverter (4) which is located physically separated from the direct voltage converters (3),
**characterised in that**
the direct voltage converters (3) are located in a single generator junction box (5), and
that a control device (16) is located inside the generator junction box (5) which can carry out the monitoring of the phase current and is connected to a central inverter (4) via a communication line (13).

2. Photovoltaic system according to Claim 1, **characterised in that** the direct voltage converters (3) galvanically isolate the connected modular strings (2) from the power inverter (4).

## Revendications

1. Installation photovoltaïque
avec des modules photovoltaïques (1), qui sont connectés en plusieurs branches de modules (2),
sachant que les branches de modules (2) sont reliées chacune à un convertisseur de tension continue (3) y associé, et
que les sorties du convertisseur de tension continue (3) sont appliquées à l'entrée d'un onduleur commun (4),
qui est disposé en étant localement séparé des convertisseurs de tension continue (3),
**caractérisée en ce**
**que** les convertisseurs de tension continue (3) sont disposés dans une boite unique de raccordement de générateur (5), et
**que**, à l'intérieur de la boite de raccordement de générateur (5), est disposé un dispositif de commande (16), qui peut exécuter un contrôle du courant des branches et est relié à un onduleur central (4) par l'intermédiaire d'une ligne de communication (13).

2. Installation photovoltaïque selon la revendication 1, **caractérisée en ce que** les convertisseurs de tension continue (3) séparent galvaniquement de l'onduleur (4) les branches de modules (2), raccordées.
